Europäisches Patentamt

European Patent Office

Office européen des brevets

(19)

(11) Publication number: **0 019 632**
**A1**

# EUROPEAN PATENT APPLICATION

published in accordance with Art. 158(3) EPC

(21) Application number: 79900540.0

(22) Date of filing: 17.05.79

Data of the international appli-
cation taken as a basis:

(86) International application number:
**PCT/JP 79/00128**

(87) International publication number:
**WO 79/01101 (13.12.79 79/25)**

(51) Int. Cl.³: **H 03 H 9/25, H 03 H 9/125,
H 03 H 3/02, H 01 L 41/08**

(30) Priority: 23.05.78 JP 61346/78

(71) Applicant: **KABUSHIKI KAISHA SUWA SEIKOSHA, 4-3-4,
Ginza Chuo-ku, Tokyo (JP)**

(43) Date of publication of application: **10.12.80
Bulletin 80/25**

(72) Inventor: **MOMOSAKI, Eishi, 3-5, Owa 3-chome,
Suwa-shi, Nagano 392 (JP)**

(74) Representative: **Flechner, Willy, c/o CABINET
FLECHNER 63, Avenue des Champs Elysées,
F-75008 Paris (FR)**

(84) Designated Contracting States: **FR**

(54) **QUARTZ CRYSTAL RESONATOR.**

(57) A tuning fork type quartz crystal resonator may be used to generate higher harmonic oscillations at the base portion thereof by appropriate selection of the width (W) and thickness (t) of an arm portion of the resonator as well as the cut angle of the original crystal. This tuning fork type quartz crystal resonator generating higher harmonic oscillations shows stable characteristics against temperature changes.

ACTORUM AG

EP 0 019 632 A1

## Quartz Crystal Vibrator

This invention relates to a tuning fork type quartz crystal vibrator which vibrates in a mode of flexural vibration as a time standard source for electronic wristwatches and which frequency change against the temperature change is small.

With the development of electronic timepieces capable of great accuracy, it has become necessary to increase the accuracy of the quartz crystal vibrator used as a time standard source in each of the timepieces. At present, the tuning fork type quartz crystal vibrator vibrating in a mode of tuning fork vibration ( the mode of vibration at a base portion is a fundamental mode ) is used mainly. Such a tuning fork type quartz crystal vibrator, however, has a resonant frequency-temperature characteristic which is a parabolic curve against the temperature, so the resonant frequency changes according to the external temperature change as shown by the parabolic curve. Accordingly, such a quartz crystal vibrator is not suitable for use with highly accurate time standard source. Nowadays, as taught by the U.S. patent No. 3,373,379, a capacitor comprising barium titanate as a principal constituent is used to compensate the above-mentioned temperature characteristic. In such a temperature compensation, however, there are problems such as variation in characteristic of the barium titanate capacitor provided to a quartz crystal oscillation circuit, aging and the like. Therefore, it is also unsuitable for use with highly accurate time standard source. In addition, since the shape of tuning fork type quartz crystal vibrator is formed by machining at present, miniaturization and mass-production is impossible. Accordingly, the present tuning fork type quartz crystal vibrators have many faults for use with miniaturized, highly accurate time standard source for electronic wristwatches.

A conventional quartz crystal vibrator will be described in accordance with the drawings.

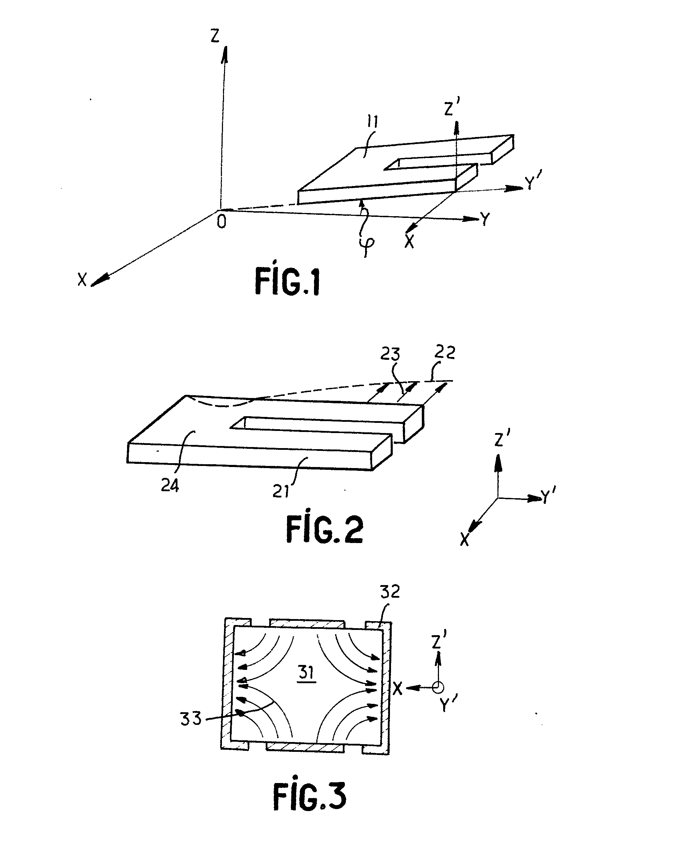

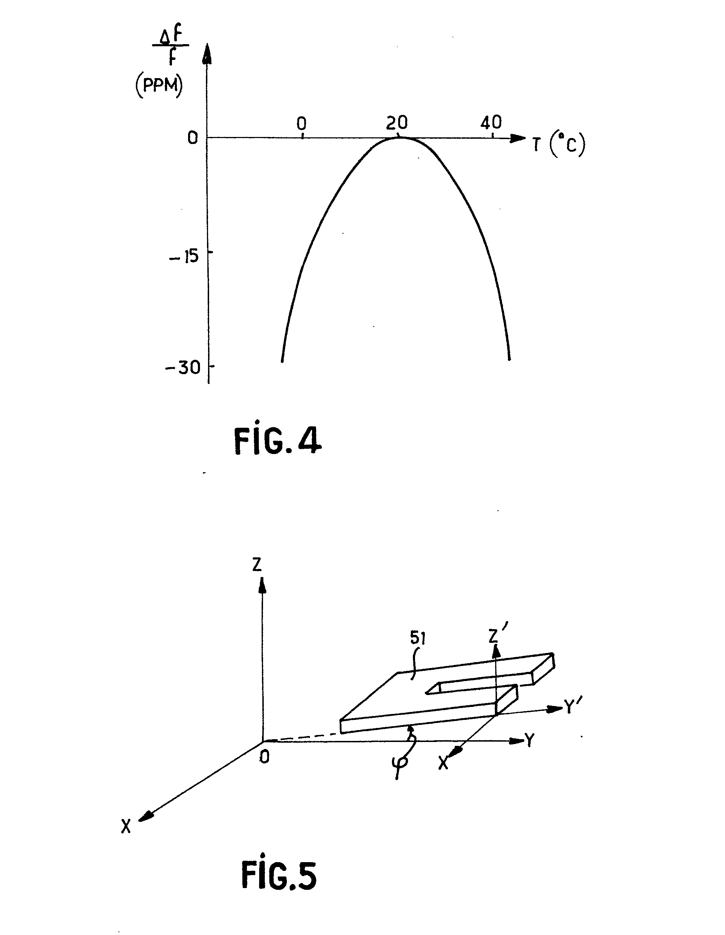

Fig. 1 shows a method of cutting conventional tuning fork type quartz crystal vibrator from the natural crystal, defining a cutting angle and crystal axes. In Fig. 1, X,Y and Z-axes are the electrical axis, the mechanical axis and the optical axis, respectively. The angle $\psi$ is about 2° to 5°. A mode of vibration of this tuning fork type quartz crystal vibrator is shown in Fig. 2. 21 is a quartz crystal vibrator, curve 22 shows a mode of tuning fork vibration (mode of flexural vibration ), arrows 23 indicating the direction of displacement. As seen in Fig. 2, the mode of vibration is a fundamental mode at the base portion 24 of the tuning fork, namely a portion lower than tine of the tuning fork. Fig. 2 only shows one side of a symmetrical mode of the tuning fork vibration. Fig. 3 is a sectional view showing one side of electrode arrangement for excitation in case of Fig. 2. Fig. 4 shows a resonant frequency-temperature characteristic of this tuning fork type quartz crystal vibrator. It can be seen from Fig. 4 that the resonant frequency decreases by about 15 ppm when the temperature is changed from the "crown" temperature of 20°C either down to 0°C or up to 40°C.

As aforesaid, since the conventional tuning

3

fork type quartz crystal vibrators had a bad resonant frequency-temperature characteristic, solutions to this problem such as compensation by another element, for example, barium titanate capacitor etc., have been performed. In such a compensation method, however, the characteristics of this additional element, namely variation in characteristics, aging and the like have been a large problem. Accordingly, it has been expected to provide a quartz crystal vibrator which itself has the good frequency-temperature characteristic as the highly accurate time standard source.

On the other hand, the conventional quartz crystal vibrators are formed with wire saw. However, this manufacturing method has many problems, that is to say, there is a limitation in miniaturization, a permanent set produced in the quartz crystal vibrator by processing one by one causes the aging in characteristics of the quartz crystal vibrator, and the like. Therefore, it has been greatly expected to provide a quartz crystal vibrator formed by manufacturing method capable of overcoming these problems and having the good frequency-temperature characteristic as the highly accurate time standard source.

This invention eliminates the aforesaid disadvantages, improves the resonant frequency-temperature characteristic of the tuning fork type quartz crystal vibrator experiencing a tuning fork vibration and provides a manufacturing method to realize miniaturization and mass-production, thereby making it possible to put a tuning fork type quartz crystal vibrator into practical use as a miniaturized, highly accurate time standard source for electronic timepieces etc.

By manufacturing tuning fork type quartz crystal vibrators taking into consideration the angle of cutting them from the natural crystal, length $\ell$, width w and thickness t of a vibrating arm, the mode of second overtone is given to the base portion of the quartz crystal vibrator. This invention thus decreases the frequency change against the temperature change as small as possible. Moreover, by manufacturing tuning fork type quartz crystal vibrators by photolitographic technique, this invention also realizes miniaturization thereof.

Figs. 1 and 2 are perspective views of a conventional tuning fork type quartz crystal vibrator. Fig. 3 is a sectional view thereof and Fig. 4 shows a frequency-temperature characteristic thereof.

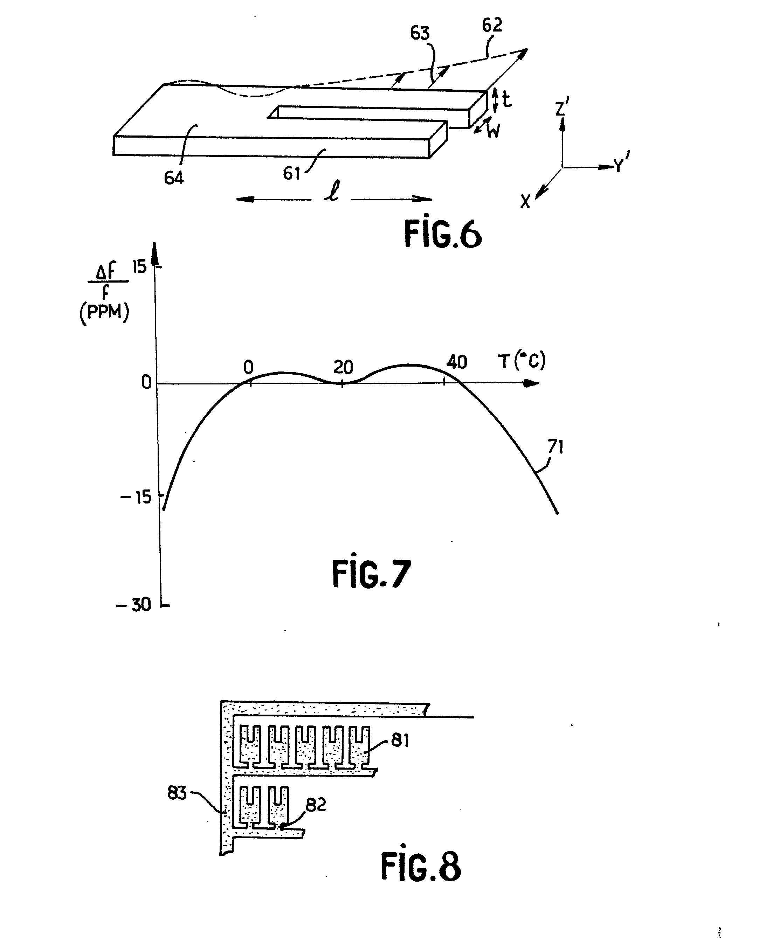

Figs. 5 and 6 are perspective views of the tuning fork type quartz crystal vibrator according to this invention and Fig. 7 shows a frequency-temperature characteristic thereof. Fig. 8 is a plan view showing a manufacturing process of the tuning fork type quartz crystal vibrator according to this invention.

This invention will be described in further detail according to Fig. 5 and Figs. following Fig. 5. Fig. 5 shows an embodiment of the tuning fork type quartz crystal vibrator according to this invention, wherein the angle of cutting it from the natural crystal is shown. The angle $\varphi$ is ordinarily 0° to 10°. Fig. 6 is a perspective view showing the embodiment of the tuning fork type quartz crystal vibrator according to this invention, wherein the mode of vibration thereof is shown. 61 is a tuning fork type quartz crystal vibrator, 62 shows a mode of tuning fork vibration, 63 shows a direction of displacement and 64 is a base portion, namely a portion lower than tine of the tuning fork. The electrodes for excitation are arranged in the same manner as in Fig. 3. Fig. 6 shows one side of the mode of tuning fork vibration. It can

5

be seen from Fig. 6 that the mode of vibration at the base portion 64 is a mode of second overtone. In case of such the tuning fork vibration that the mode of vibration at the base portion is the mode of overtone, the frequency-temperature characteristic is as shown in Fig. 7. In this case, $\ell/w \doteqdot 8$ and $t/w \doteqdot 1.2$, where $\ell$ represents length of the vibrating arm, w represents width of one side thereof and t represents thickness thereof. As seen from Fig. 7, the resonant frequency of the tuning fork type quartz crystal vibrator according to this invention only varies by about 2 ppm for a temperature range of 0°C to 40°C. It is a very good charracteristic as compared with the conventional tuning fork type quartz crystal vibrators, the resonant frequency of which varies by as much as 15 ppm. Although Fig. 5 shows a case where the mode of vibration at the base portion is the second overtone, also in case of the mode more than third overtone, the characteristic as shown in Fig. 7 can be obtained by properly selecting the angle $\varphi$ shown in Fig. 5. The characteristic described above can be obtained by performing a vibration analysis even taking the vibration produced at the base portion 64 of the quartz crystal vibrator into consideration and also by carrying out experiments. As above mentioned, by employing such the mode of vibration that the mode of vibration at the base portion is that of overtone, a great improvement in the frequency-temperature characteristic of the tuning fork vibration has been attained.

Referring now to a manufacturing method of quartz crystal vibrators according to this invention, they can be made also by a conventional manufacturing method, namely by cutting with wire saw or the like and then individually finishing each of them to be a tuning fork type. However, manufacture in this way involves a large number of process steps, mass-production and miniaturization being impossible. Moreover, there is a large variation in the shape and in the characteristics of each vibrator produced by such a process. In addition, the aging occurs to the characteristics thereof due to the permanent set caused by process. Manufacturing method according to this invention eliminates these disadvantages and provides miniaturization as well as mass-production of the tuning fork type quartz crystal vibrators having the aforementioned excellent performance.

That is to say, the quartz crystal plate cut from the natural crystal is ground to a thin plate and then coated with chrome and gold on both surfaces thereof by vacuum deposition or by spattering. Next, photo-etching is carried out using a glass mask on which the pattern of the tuning fork type quartz crystal vibrator is printed. The deposit of chrome and gold is removed from the selected positions of the vibrator to produce the desired pattern, after which the quartz crystal plate is etched in ammonium fluoride or in hydrofluoric acid, thereby producing the tuning fork type quartz crystal vibrator in large quantities at the same time. As occasion demands, the electrode pattern may be made in the same manner. Fig. 8 is a plan view showing an embodiment of the tuning fork type quartz crystal vibrator produced by the above mentioned process steps. 81 is many tuning fork type quartz crystal vibrators connected to one another. By wresting connections 82, individual tuning fork type quartz crystal vibrators are obtained. 83 is a frame.

As above mentioned, by utilizing the photolithographic process according to this invention, it has been possible to produce the tuning fork type quartz crystal vibrators with high performance as well as with small variation in performance, and further to miniaturize and mass-produce them, thereby making it possible to put the tuning fork type quartz crystal vibrators according to this invention into practical use as the highly accurate time standard source for electronic wristwatches.

As seen from the foregoing, since the tuning fork type quartz crystal vibrator according to this invention is miniaturized and has characteristic of small frequency change against the temperature change, this invention is applicable to small apparatuses which require high accuracy, especially to quartz crystal wristwatches.

8

## CLAIMS

1. A tuning fork type quartz crystal vibrator using such a mode of tuning fork vibration that a mode of vibration at a base portion of said tuning fork type quartz crystal vibrator is a mode of overtone.

2. A tuning fork type quartz crystal vibrator as claimed in claim 1, being characterized in that said tuning fork type quartz crystal vibrator is made of a quartz crystal plate by photolithographic process.

0019632

9

Amended claims under Art. 19 of the PCT

1. A tuning fork type quartz crystal vibrator using such a mode of tuning fork vibration that a mode of vibration at a base portion of said tuning fork type quartz crystal vibrator is a mode of overtone.

2. A tuning fork type quartz crystal vibrator as claimed in claim 1, being characterized in that said tuning fork type quartz crystal vibrator is made of a quartz crystal plate by photolithographic process.

3. A tuning fork type quartz crystal vibrator as claimed in claim 2, being characterized in that a plurality of said tuning fork  type quartz crystal vibrators are made at the same time.

0019632

1/3

FIG.1

FIG.2

FIG.3

FIG.4

FIG.5

FiG.6

FiG.7

FiG.8

International Application No PCT/JP79/00128

## I. CLASSIFICATION OF SUBJECT MATTER (if several classification symbols apply, indicate all)

According to International Patent Classification (IPC) or to both National Classification and IPC

H03H 9/18, H03H 9/04, H03H 3/02

## II. FIELDS SEARCHED

### Minimum Documentation Searched

| Classification System | Classification Symbols |
|---|---|
| I P C | H03H 9/14 ～ 9/20, 9/00 ～ 9/08, H03H 3/02 ～ 3/04 |

### Documentation Searched other than Minimum Documentation to the Extent that such Documents are Included in the Fields Searched

| | |
|---|---|
| Jitsuyo Shinan Koho | 1935 ～ 1979 |
| Kokai Jitsuyo Shinan Koho | 1971 ～ 1979 |

## III. DOCUMENTS CONSIDERED TO BE RELEVANT

| Category | Citation of Document, with indication, where appropriate, of the relevant passages | Relevant to Claim No. |
|---|---|---|
| A | JP.A.51-147294.1976-12-17 | 1 |
| A | JP.A.48-3575. 1973- 1-17 | 2 |

* Special categories of cited documents:

"A" document defining the general state of the art

"E" earlier document but published on or after the international filing date

"L" document cited for special reason other than those referred to in the other categories

"O" document referring to an oral disclosure, use, exhibition or other means

"P" document published prior to the international filing date but on or after the priority date claimed

"T" later document published on or after the international filing date or priority date and not in conflict with the application, but cited to understand the principle or theory underlying the invention

"X" document of particular relevance

## IV. CERTIFICATION

| Date of the Actual Completion of the International Search | Date of Mailing of this International Search Report |
|---|---|
| August 17, 1979 (17.08.79) | September 3, 1979 (03.09.79) |

| International Searching Authority | Signature of Authorized Officer |
|---|---|
| Japanese Patent Office | |

Form PCT/ISA/210 (second sheet) (October 1977)